(19) Europäisches Patentamt

European Patent Office

Office européen des brevets

(11) Veröffentlichungsnummer: **0 304 737 B1**

# (12) EUROPÄISCHE PATENTSCHRIFT

(45) Veröffentlichungstag der Patentschrift: **08.12.93**

(21) Anmeldenummer: **88113107.2**

(22) Anmeldetag: **12.08.88**

(51) Int. Cl.⁵: **H03D 7/18,** H03B 21/02

(54) **Verfahren zum Vermindern von Störsignalen eines Mischers und Mischer zur Durchführung des Verfahrens.**

(30) Priorität: **22.08.87 DE 3728020**

(43) Veröffentlichungstag der Anmeldung:
**01.03.89 Patentblatt 89/09**

(45) Bekanntmachung des Hinweises auf die
Patenterteilung:
**08.12.93 Patentblatt 93/49**

(84) Benannte Vertragsstaaten:
**CH DE FR GB LI**

(56) Entgegenhaltungen:
**FR-A- 1 350 673**
**GB-A- 2 135 844**

**IEEE TRANSACTIONS ON AUDIO AND ELEC-**
**TROACOUSTICS, Band AU-19, Nr. 1, März**
**1971, Seiten 48-57, New York, US; J. TIERNEY**
**et al.: "A digital frequency synthesizer"**

**PATENT ABSTRACTS OF JAPAN, Band 9, Nr.**
**266 (E-352)[1989], 23. Oktober 1985; & JP-**
**A-60 113 505 (SONY K.K.) 20-06-1985**

**ELECTRONICS LETTERS, Band 15, Nr. 12,**
**Juni 1979, Seiten 350-352; G.F. MANES et al.:**
**"Discrete frequency synthesis using an ana-**
**logue R.O.M."**

(73) Patentinhaber: **Spectrospin AG**
**Industriestrasse 26**
**CH-8117 Zürich-Fällanden(CH)**

(72) Erfinder: **Kuster, Anton**
**Müllerweis 25**
**CH-8606 Greifensee(CH)**
Erfinder: **Käppeli, Roland**
**Sonnenrain**
**CH-8336 Oberhittnau(CH)**

(74) Vertreter: **KOHLER SCHMID + PARTNER**
**Patentanwälte**
**Ruppmannstrasse 27**
**D-70565 Stuttgart (DE)**

EP 0 304 737 B1

## Beschreibung

Die Erfindung betrifft ein Verfahren zum Vermindern des Anteils an Störsignalen einschl. der Spiegelfrequenz im Ausgangssignal eines Mischers, der mindestens zwei Modulatoren aufweist, denen an ihrem ersten Eingang ein Trägersignal der Frequenz $f_0$ und an ihrem zweiten Eingang ein Modulationssignal der Frequenz $f_m$ derart zugeführt wird, daß die dem einen der mindestens zwei Modulatoren zugeführten Träger- und Modulationssignale gegenüber dem dem mindestens einen anderen Modulator zugeführten Träger- bzw. Modulationssignal eine vorgegebene Phasenverschiebung aufweisen, und deren Ausgangssignale zu dem Ausgangssignal des Mischers kombiniert werden, dessen Frequenz gleich der Summe der Frequenzen des Trägersignals und des Modulationssignals ist.

Solche Mischer sind allgemein in Form von Quadraturmischern bekannt, die zwei Modulatoren enthalten, denen das Modulationssignal um 90° phasenverschoben zugeführt wird. Diese Quadraturmischer haben verbreitet Anwendung gefunden, weil theoretisch außer dem gewünschten Ausgangssignal mit der Summenfrequenz $f_0 + f_m$ oder $f_0 - f_m$ alle anderen Mischprodukte einschl. der Spiegelfrequenz unterdrückt werden. Tatsächlich ist jedoch selbst bei sehr sorgfältiger Abstimmung der Ringmodulatoren kein reines Ausgangssignal der Frequenz $f_0 + f_m$ oder $f_0 - f_m$ erreichbar, sondern es treten auch Ausgangssignale mit den Frequenzen der anderen Mischprodukte auf. Die Gründe dafür liegen im wesentlichen darin, daß dis Kennlinien der Modulatoren nicht rein quadratisch sind, daß keine vollständige Symmetrie der Modulatoren erzielbar ist, daß im Modulator verwendete 90°-Phasenschieber frequenz- und lastabhängig sind, daß ein Übersprechen im Schaltungsaufbau stattfindet und daß endlich die Ein- und Ausgangsimpedanzen der Modulatoren nicht konstant sind. Daher ist die bisher mit solchen Quadraturmischern erreichbare Unterdrückung der unerwünschten Mischprodukte nur bis zu etwa 30 db gegenüber dem Ausgangssignal mit der Summenfrequenz möglich und es werden komplizierte Schaltungsanordnungen verwendet, um entstehende Störsignale zu unterdrücken, wie beispielsweise die aus DE 35 16 492 A1 bekannten Kompensationsschaltungen, die von vier Modulatoren Gebrauch machen.

Andererseits hat der Quadraturmischer eine erhebliche Bedeutung, und zwar nicht nur als Modulator oder Demodulator, sondern auch als HF-Generator hoher Stabilität. Dabei kann zur Erzeugung des HF-Trägersignals ein Oszillator hoher Stabilität verwendet werden, während zur Erzeugung des Mischsignales ein Generator ausreicht, dessen Stabilität um den gleichen Faktor, um den die Frequenz des Modulationssignales kleiner ist als die Frequenz des Trägersignales, geringer ist als die Stabilität des das Trägersignal erzeugenden Oszillators. Gerade für die Anwendungen, für die solche hochstabilen Generatoren benötigt werden, ist es auch wichtig, daß das Ausgangssignal von hoher Reinheit ist, so daß es zu begrüßen wäre, wenn es gelänge, die Reinheit des Ausgangssignals eines solchen Quadraturmischers zu verbessern, ohne daß der Schaltungsaufwand durch die Anwendung zusätzlicher Baugruppen wie Modulator- und Additions- bzw. Subtraktionsstufen erhöht wird, zumal grundsätzlich alle Baugruppen selbst in einem gewissen Umfange zur Signalverzerrung beitragen und damit dem Erzeugen eines Ausgangssignales sehr großer Reinheit entgegenwirken.

Demgemäß liegt der Erfindung die Aufgabe zugrunde, ein Verfahren anzugeben, das es ermöglicht, mit geringem Aufwand ein von unerwünschten Mischfrequenzen weitgehend freies Ausgangssignal eines Mischers zu erzielen.

Diese Aufgabe wird nach der Erfindung dadurch gelöst, daß jedem Modulator als Modulationssignal eine Folge von M Gleichspannungssignalen mit einer der gewünschten Modulationsfrequenz $f_m$ entsprechenden Folgefrequenz zugeführt wird und die einzelnen Gleichspannungssignale jeder Folge eine solche Größe haben, daß die Kombination der allen Modulatoren gleichzeitig zugeführten m-ten Gleichspannungssignale ein Ausgangssignal des Mischers ergibt, das die Frequenz des Trägersignals, eine für alle Kombinationen der Gleichspannungssignale gleiche vorgegebene Amplitude und eine der jeweiligen Kombination der Gleichspannungssignale zugeordnete Phasenlage $m*(360°/M)$, wobei M und m ganze Zahlen mit $1 \leq m \leq M$ sind, aufweist, derart, daß die Endpunkte der für die Amplitude und die Phasenlage dieser Ausgangssignale charakteristischen Vektoren schrittweise einen vollständigen Kreis beschreiben, wobei die Folgen von M Gleichspannungssignalen experimentell ermittelt werden, und wobei sie verzerrte Sinus-Funktionen darstellen, deren Verzerrungen die Fehler des Mischers kompensieren.

Bei dem erfindungsgemäßen Verfahren wird also nicht versucht, die unerwünschten Mischsignale durch einen den theoretischen Anforderungen möglichst weitgehend entsprechende Verfeinerung des Schaltungsaufbaus oder durch komplizierte Kompensationsmaßnahmen zu beseitigen, sondern es werden die dem Schaltungsaufbau innewohnenden Mängel bewußt in Kauf genommen und dadurch ausgeglichen, daß den Modulatoren in einer solchen Weise modifizierte Modulationssignale zugeführt werden, daß sich ein nahezu ideales Ausgangssignal ergibt. Bei einem Quadraturmischer, in dessen Ausgangssignal die unerwünschten Mischprodukte um etwa 20 db unterdrückt waren, konnte durch Anwendung des erfindungsgemäßen Verfahrens ohne weiteres eine Unterdrükkung der unerwünschten Mischprodukte bis auf etwa 50 db erzielt werden. Die dadurch erzielte Verbesserung in der Leistungsfähigkeit eines Quadraturmischers eröffnet neue Anwendungsbereiche und bietet die Möglichkeit zur Lösung mancher Probleme, die bei der Frequenzaufbereitung in spektroskopischen Geräten auftreten, die HF-Signale hoher Stabilität und Reinheit benötigen, wie insbesondere in der magnetischen Kernresonanz, der Ionencyclotronresonanz u. dgl.

Die Erfindung bietet den weiteren Vorteil, daß sie nicht nur bei Quadraturmischern anwendbar ist, die zwei Ringmodulatoren aufweisen, sondern auch einen völlig neuartigen Aufbau eines Mischers unter Verwendung von drei oder vier elektronisch steuerbaren Dämpfungsgliedern als Modulatoren ermöglicht, denen das Trägersignal mit einer relativen Phasenverschiebung von 120° bzw. 90° zugeführt wird. Dabei kann sogar eines der Dämpfungsglieder auf eine vorgegebene konstante Dämpfung eingestellt sein. Obwohl bei der Verwendung von Dämpfungsgliedern die Anzahl der benötigten Bauelemente größer ist als bei der Verwendung von Ringmodulatoren, so ist doch der Aufbau eines Dämpfungsgliedes sehr viel einfacher als derjenige eines Ringmodulators, so daß sich insgesamt eine bedeutende Vereinfachung im Aufbau eines Mischers ergibt.

Die Erzeugung der an die Eingänge der Modulatoren anzulegenden Gleichspannungen kann auf vielfältige Weise erfolgen, beispielsweise durch Verwendung von Korrektureinrichtungen, die den das Modulationssignal erzeugenden Oszillatoren nachgeschaltet sind, aber auch durch Aufzeichnen und Auslesen der ermittelten Spannungswerte in analoger oder digitaler Form.

Besonders bevorzugt wird eine Ausführungsform des erfindungsgemäßen Verfahrens, bei dem die Spannungswerte der einzelnen Kombinationen von Gleichspannungssignalen als digitale Zahlen gespeichert, mit einer die gewünschte Modulationsfrequenz ergebenden Taktfrequenz gelesen und dann in entsprechende Analogsignale umgesetzt werden, die den Modulatoren zugeführt werden.

Die Anwendung dieses Verfahrens hat nicht nur den besonderen Vorteil, daß das Abrufen der jeweils benötigten Spannungswerte mit hoher Genauigkeit möglich ist, sondern es ist auch relativ einfach, die zu speichernden digitalen Zahlen jeweils so lange zu ändern, bis der Quadraturmischer das Ausgangssignal mit der vorgegebenen Amplitude und der gewünschten Phasenlage liefert, und dann die so ermittelten Zahlen an dem der jeweiligen Phasenlage zugeordneten Platz zu speichern.

Es sind zwar aus DE 30 07 907 A1 und aus US 40 90 145 digitale Mischer bekannt, bei denen die Modulationssignale durch Auslesen von Zahlenwerten aus Sinus- und Cosinus-Tabellen erzeugt werden, jedoch werden bei diesen bekannten Mischern die Modulatoren von digitalen Multiplizierern gebildet, denen auch das zu überlagernde HF-Signal nach einer A/D-Umsetzung als Folge von digitalen Zahlen zugeführt wird und deren Ausgangssignal ein digitales Signal ist, das auch digital weiterverarbeitet wird.

Der Unterschied zwischen dieser Ausführungsform des erfindungsgemäßen Verfahrens und dem genannten stand der Technik besteht aber nicht nur darin, daß ein Quadraturmischer mit herkömmlichem Aufbau verwendet und das Modulationssignal für die Modulatoren dadurch erzeugt wird, daß aus einer Sinus- bzw. Cosinus-Tabelle in einem die Modulationsfrequenz bestimmenden Takt ausgelesenen Zahlen in ein Analogsignal umgesetzt werden. Vielmehr treten bei Anwendung des erfindungsgemäßen Verfahrens an die Stelle der Zahlen der Sinus- bzw. Cosinus-Tabelle die experimentell ermittelten Werte, welche tatsächlich das Ausgangssignal mit der vorgegebenen Amplitude und der Phasenlage liefern. die mit der Phasenlage übereinstimmt, welcher die gespeicherten Werte zugeordnet sind.

Gegenstand der Erfindung ist auch ein Mischer mit mindestens zwei jeweils zwei Eingänge aufweisenden Modulatoren, einem ersten HF-Generator zur Erzeugung eines Trägersignals mit der Frequenz $f_0$, dessen Ausgang mit dem ersten Eingang des einen Modulators direkt und mit dem ersten Eingang des mindestens einen anderen Modulators über einen Phasenschieber verbunden ist, und einem Generator zur Erzeugung von einer der Anzahl der Modulatoren gleichen Anzahl gegeneinander phasenverschobenen Modulationssignalen mit der Frequenz $f_m$, von denen jeweils eines dem zweiten Eingang eines der Modulatoren zugeführt wird. Nach der Erfindung ist der Generator zur Erzeugung der gegeneinander phasenverschobenen Modulationssignale als Digital-Synthesizer ausgebildet, welcher Speicher für Zahlen, die Winkelwerten zugeordneten Spannungswerten des Modulationssignals entsprechen, den Speichern nachgeschaltete Digital/Analog-Umsetzer, deren Ausgänge mit dem zweiten Eingang je eines der Modulatoren verbunden sind, und eine Einrichtung zum Auslesen der Zahlen aus den Speichern nach einem die Modulationsfrequenz bestimmenden Takt und Zuführen der Zahlen zu den Digital/Analog-Umsetzern umfaßt, welche den Modulatoren den Zahlen entsprechende Spannungswerte zuführen. Die Speicher enthalten für jeden Winkelwert eine experimentell ermittelte Zahlenkombination, die als Ausgangssignal des Mischers ein Signal mit der Trägerfrequenz und vorgegebener fester Amplitude und einer mit dem Winkelwert übereinstimmenden Phasenlage ergibt, wobei die den Zahlen entsprechenden Spannungswerte, die den Modulatoren zugeführt werden, verzerrte Sinus-Funktionen darstellen, deren Verzerrungen die Fehler des Mischers kompensieren.

Wie bereits erwähnt, kann es sich bei einem solchen Mischer um einen Quadraturmischer mit zwei Ringmodulatoren handeln. Die Modulatoren des Mischers können aber auch von drei oder vier elektronisch gesteuerten Dämpfungsgliedern gebildet werden. Im Fall von vier Dämpfungsgliedern oder Attenuatoren müssen Träger- und Modulationssignal in jeweils vier zyklisch um 90° phasenverschobene Anteile aufgespalten werden (0°, 90°, 180°, 270°). Das Ausgangssignal setzt sich dann aus vier Teilsignalen zusammen, die aus Paaren von um 180° verschobenen Anteilen bestehen, so daß jedes Paar ähnlich wie ein Ringmodulator beliebige positive und negative Beiträge zum Ausgangssignal des Mischers liefern kann. Dann ist es auch nicht nötig, die Attenuatoren ganz auf Null zu fahren.

Da es nur darauf ankommt, die Möglichkeit zu haben, ein Ausgangssignal mit konstanter Amplitude und mit beliebiger Phase zu erzeugen, reicht es grundsätzlich aus, wenn zwei linear unabhängige Modulationssignale verwendet werden. Da die Phase um volle 360° geschoben werden soll, muß bei Verwendung von einfachen Attenuatoren, die keinen Vorzeichenwechsel zulassen, von mindestens drei Attenuatoren ausgegangen werden. Eine symmetrische Anordnung bewirkt das Aufspalten der Signale in jeweils drei um 120° phasenverschobene Anteile. Grundsätzlich reicht es sogar aus, den Abschwächfaktor eines Attenuators konstant zu halten und nur die beiden anderen zu variieren. Es muß nur immer die Bedingung erfüllt sein, daß sich die Beiträge zu einem Gesamtsignal mit festem Betrag und gewünschter Phasenlage addieren. Unter dieser Voraussetzung können die Modulationsspannungen für die beiden Ringmodulatoren oder für die drei oder vier Attenuatoren des Mischers frei gewählt werden. Insbesondere ergeben sich damit auch für ideal funktionierende elektronische Bauelemente für die einzelnen Modulationssignale nicht mehr notwendigerweise sinusförmige Verläufe als Funktion der Phase des Ausgangssignals. In diesen Fällen muß allerdings in Kauf genommen werden, daß die Einzelsignale phasenweise betragsmäßig größer als das Ausgangsignal sein müssen.

Die Erfindung wird im folgenden anhand der in der Zeichnung dargestellten Ausführungsbeispiele näher beschrieben und erläutert. Die der Beschreibung und der Zeichnung zu entnehmenden Merkmale können bei anderen Ausführungsformen der Erfindung einzeln für sich oder zu mehreren in beliebiger Kombination Anwendung finden. Es zeigen:

Fig.1      das Blockschaltbild eines Quadraturmischers,

Fig. 2      das Spektrum des Ausgangssignales des Quadraturmischers nach Fig. 1 unter Verwendung von Sinus- und Cosinus-Tabellen nach dem Stand der Technik,

Fig. 3      das Spektrum des Ausgangssignals des Quadraturmischers nach Fig. 1 unter Verwendung von experimentell ermittelten Spannungswerte-Tabellen nach der Erfindung,

Fig. 4      die Spektren weiterer nach dem erfindungsgemäßen Verfahren erhaltener Ausgangssignale des Quadraturmischers nach Fig. 1,

Fig. 5      das Blockschaltbild eines Schaltungsaufbaus zur Ermittlung der nach der Erfindung zu verwendenden Wertepaare,

Fig. 6      das Blockschaltbild eines nach der Erfindung ausgebildeten Mischers mit drei elektronisch steuerbaren Dämpfungsgliedern,

Fig. 7      ein Zeigerdiagramn, das die Kombination der Ausgangssignale der Dämpfungsglieder zum Ausgangssignal des Mischers nach Fig, 6 veranschaulicht, und

Fig. 8      ein Zeigerdiagramm ähnlich Fig. 7 für einen Mischer mit vier Dämpfungsgliedern.

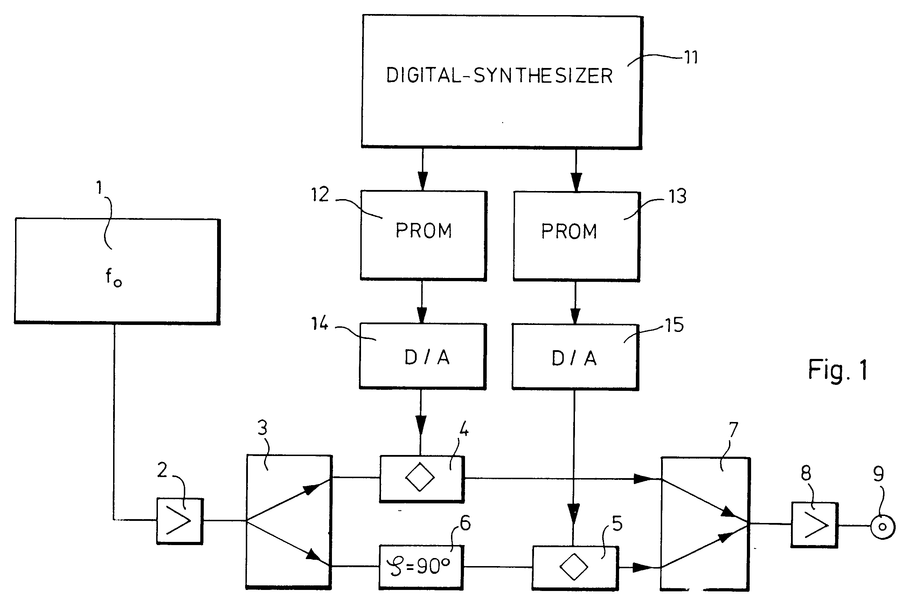

Fig. 1 zeigt einen herkömmlichen Quadraturmischer zur Erzeugung eines HF-Signals variabler Frequenz durch Mischen einer Trägerfrequenz $f_0$ und einer Modulationsfrequenz $f_m$. Demgemäß weist die dargestellte Schaltungsanordnung einen HF-Generator 1 zur Erzeugung eines Signals mit der Trägerfrequenz $f_0$ auf. Dabei kann es sich um einen Quarzoszillator hoher Stabilität handeln. Für übliche Anwendungen liegt die Trägerfrequenz $f_0$ im Bereich von einigen hundert Megahertz.

Das Ausgangssignal des HF-Generators 1 wird über einen Verstärker 2 einem Leistungsteiler 3 zugeführt, dessen Ausgänge mit einem ersten Ringmodulator 4 direkt und mit einem zweiten Ringmodulator 5 über einen 90°-Phasenschieber 6 verbunden sind. Die Ausgangssignale der Ringmodulatoren 4 und 5 werden mittels eines Additionskreises 7 vereinigt und dann über einen weiteren Verstärker 8 dem Ausgang 9 des Quadraturmischers zugeführt.

Die den Ringmodulatoren 4 und 5 zuzuführenden Modulationssignale der Frequenz $f_m$ werden von einer Schaltungsanordnung erzeugt, die einen Digital-Synthesizer 11, zwei digitale Speicher 12 und 13 und zwei Digital/Analog-Umsetzer 14 bzw.

15 umfaßt, deren Ausgänge jeweils mit einem der Modulationseingänge der Ringmodulatoren 4 und 5 verbunden sind. In den Speichern 12 und 13, bei denen es sich beispielsweise um PROMs handeln kann, sind an Stellen, die den Winkelwerten einer periodischen Schwingung zugeordnet sind, Spannungswerten entsprechende Zahlen gespeichert, die in Abhängigkeit von dem vom Digital-Synthesizer 11 zugeführten Signalen ausgelesen und dem zugeordneten Digital/Analog-Umsetzer 14 bzw. 15 zugeführt werden. Es entstehen auf diese Weise zwei um 90° gegeneinander phasenverschobene Signale mit sinus- bzw. cosinus-förmigem Verlauf, wenn in den beiden Speichern 12 und 13 eine Sinus- bzw. eine Cosinus-Tabelle gespeichert sind. Die Frequenz $f_m$ des Modulationssignals ergibt sich durch die Frequenz des vom Digital-Synthesizer 11 gelieferten Taktsignals, welches das Auslesen der Spannungswerte aus den Speichern 12, 13 bewirkt. Die Frequenz $f_m$ des auf diese Weise erzeugten Modulationssignals liegt gewöhnlich im Bereich von Null bis einigen hundert Kilohertz.

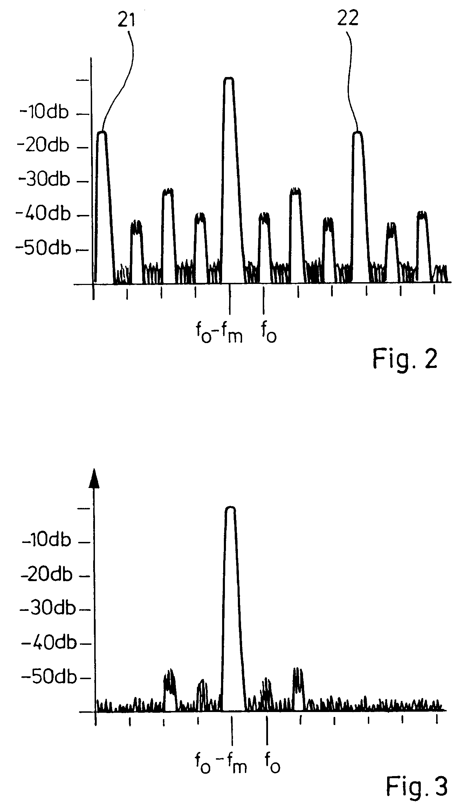

Fig. 2 zeigt das Spektrogramm des Ausgangssignals des Quadraturmischers nach Fig. 1 für den Fall, daß in herkömmlicher Weise in den Speichern 12 und 13 reine Sinus- bzw. Cosinus-Tabellen gespeichert sind. Die Trägerfrequenz $f_0$ beträgt 500 MHz und die Modulationsfrequenz $f_m$ 100 kHz. Es ist ersichtlich, daß neben der Hauptlinie mit der Frequenz $f_0 - f_m$ eine Vielzahl von weiteren Linien im Abstand von jeweils 100 kHz auftritt, die das Vorhandensein weiterer Mischprodukte anzeigen. Dabei treten Linien 21, 22 auf, die gegenüber dem gewünschten Mischsignal nur um etwa 15 db gedämpft sind.

Gemäß der Erfindung werden in den Speichern 12. 13 nicht in der bekannten Weise Sinus- bzw. Cosinus-Tabellen gespeichert, sondern experimentell ermittelte Werte, deren Umsetzung in eine den Ringmodulatoren 4, 5 zugeführte Spannung am Ausgang 9 des Quadraturmischers ein Signal mit der Trägerfrequenz $f_0$ ergibt, das, bei konstanter Amplitude des zugeführten Trägersignals, ein Ausgangssignal vorgegebener Amplitude liefert, dessen Phasenlage genau dem Winkelwert entspricht, unter dem die Größe des den Ringmodulatoren 4, 5 zugeführten Gleichspannungspaares bestimmenden Zahlenwerte gespeichert sind. Werden diese Werte mit Hilfe des Digital-Synthesizers 11 in der die Modulationsfrequenz bestimmenden Folge ausgelesen, so werden den Ringmodulatoren 4, 5 nicht sinus-förmige Signale zugeführt, sondern gegenüber Sinus-Funktionen in solcher Weise verzerrte Signale, daß die Fehler des Quadraturmischers kompensiert werden und ein Ausgangssignal erhalten wird, das neben der gewünschten Mischfrequenz $f_0 - f_m$ nur noch sehr geringe Anteile an weiteren Mischprodukten enthält. Das Ergebnis der Verwendung derart modifizierter Werte gibt Fig. 3 wieder. Wie ersichtlich, sind in dem Spektrum nach Fig. 3 die sehr starken Linien 21, 22 völlig verschwunden, und es treten nur noch in der Nachbarschaft des gewünschten Ausgangssignals mit der Frequenz $f_0 - f_m$ Linien auf, die gegenüber dem gewünschten Signal um etwa 50 db gedämpft sind. Diese mit Hilfe des erfindungsgemäßen Verfahrens erzeugte Verbesserung des Ausgangssignals des Quadraturmischers ist eklatant und bedarf keines weiteren Kommentars.

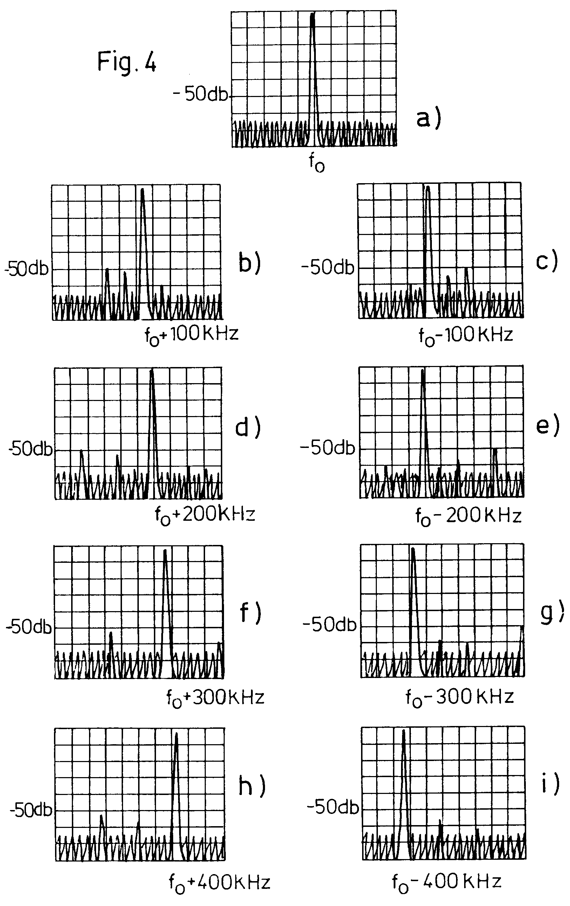

Fig. 4 zeigt weitere Diagramme von Ausgangssignalen, die mit Hilfe eines nach dem erfindungsgemäßen Verfahren arbeitenden Quadraturmischers erhalten worden sind. Das in der ersten Zeile wiedergegebene Bild (a) zeigt das Spektrogramm eines reinen Trägersignals mit der Frequenz $f_0 = 100$ MHz. Die weiteren Bilder (b) und (c) zeigen dann das Summen- bzw. Differenzsignal bei Mischung mit einer Modulationsfrequenz $f_m = 100$ kHz. Dementsprechend zeigen die jeweils darunter dargestellten Diagramme die Ergebnisse der Mischung mit Modulationssignalen der Frequenzen 200 kHz, 300 kHz und 400 kHz. Es ist ersichtlich, daß die neben dem gewünschten Ausgangssignal $f_0 \pm f_m$ erscheinenden Störkomponenten um etwa 50 db gegenüber dem gewünschten Ausgangssignal gedämpft sind. Diese Diagramme zeigen auch, daß, wie zu erwarten, die erzielte Verbesserung von der Frequenz des Modulationssignales weitgehend unabhängig ist.

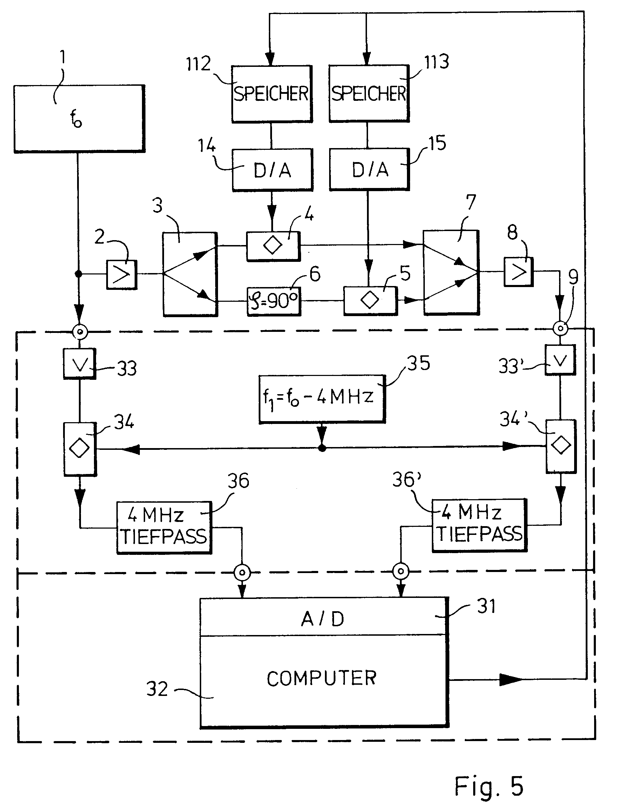

Fig. 5 zeigt eine Schaltungsanordnung, die es ermöglicht, diejenigen Spannungswerte zu ermitteln, die den Ringmodulatoren zugeführt werden müssen, um ein von Störkomponenten im wesentlichen freies Ausgangssignal zu erzielen. Der obere Teil von Fig. 5 gibt wiederum den wesentlichen Teil des in Fig. 1 dargestellten Aufbaus eines Quadraturmischers wieder, so daß dieser Schaltungsaufbau nicht erneut beschrieben werden muß. Allerdings fehlt der Digitalsynthesizer und es sind die PROMS durch Speicher 112, 113 ersetzt, in den von einem Rechner 32 ermittelte Zahlenwerte eingegeben werden können. Der Rechner 32 ist über einen umschaltbaren Analog/Digital-Umsetzer 31 an den Eingang und den Ausgang des Quadraturmischers angeschlossen. Er ist in der Lage, aus den vom Analog/Digital-Umsetzer 31 gelieferten Zahlenwerten, die die abgetasteten Werte der augenblicklichen Spannung des HF-Signales wiedergeben, die Amplitude und die Phase einer HF-Schwingung zu bestimmen. Da zum Erfassen einer Sinus-Schwingung mehr als zwei Abtastungen pro Periode erforderlich sind und, wie oben dargelegt, bei interessierenden Anwendungen die Trägerfrequenz $f_0$ im Bereich von einigen hundert Megahertz liegt, ist eine ausreichend schnelle Abtastung nicht mehr ohne weiteres möglich. Daher werden bei der in Fig. 5 dargestellten Schaltungsanordnung sowohl das von dem HF-Generator 1 gelieferte Trägersignal als auch das Ausgangssignal des Quadraturmischers dem Analog/Digital-Umsetzer 31 über jeweils einen Verstärker 33 bzw. 33' einem Ringmodulator 34 bzw. 34' zugeführt, in dem diese Signale mit einem hochfrequenten Signal überlagert werden, das von einem HF-Generator 35 geliefert wird. Die Frequenz $f_1$ beträgt beispielsweise $f_0$ - 4 MHz, so daß die Ringmodulatoren 34, 34' ein Signal mit der Frequenz f = 4 MHz verläßt. Die Ausgangssignale der Ringmodulatoren 34, 34' werden über entsprechende Tiefpässe 36, 36' dem Analog/Digital-Umsetzer 31 zugeführt. Dieser arbeitet mit einer Taktfrequenz von 10 MHz und liefert den mit dieser Frequenz abgetasteten Spannungswerten entsprechende Zahlen. Der entsprechend programmierte Rechner 32 ist dann in der Lage, die Amplitude und die Phase des von dem Ausgang 9 des Quadraturmischers abgeleiteten Signals mit der Amplitude und der Phase des von dem HF-Generator 1 gelieferten Trägersignals zu vergleichen und bei Abweichungen von dem Sollwert die in den Speichern 112, 113 enthaltenen Zahlenwerte, welche die Amplitude und die Phase des Ausgangssignals des Quadraturmischers bestimmen, so lange systematisch zu verändern, bis jeweils das transformierte Ausgangssignal die richtige Phase und die richtige Amplitude hat. Die so ermittelten Zahlenwerte werden dann dauerhaft gespeichert, insbesondere auf die im Quadraturmischer nach Fig. 1 verwendeten PROMS 12, 13 übertragen. So können nacheinander sämtliche Werte ermittelt und gespeichert werden, die einer ausreichend dichten Folge von Winkelwerten diejenigen Zahlenwerte zuordnen, welche ein Ausgangssignal des Quadraturmischers mit konstanter Amplitude und der jeweils richtigen Phasenlage ergeben. Die bei der Ermittlung dieser Werte erfolgte Frequenzumsetzung führt zu keinen nennenswerten Fehlern, weil ein unterschiedliches Verhalten der beiden Ringmodulatoren 34, 34' bei der Frequenzumsetzung lediglich das Amplitudenverhältnis und die Phasendifferenz zwischen den vom Trägersignal bzw. Ausgangssignal abgeleiteten Signalen beeinflussen, dieser Einfluß jedoch konstant ist. so daß davon weder das Einhalten eines konstanten Amplitudenverhältnisses noch die Bestimmung der jeweiligen relativen Phasenlage beeinträchtigt ist.

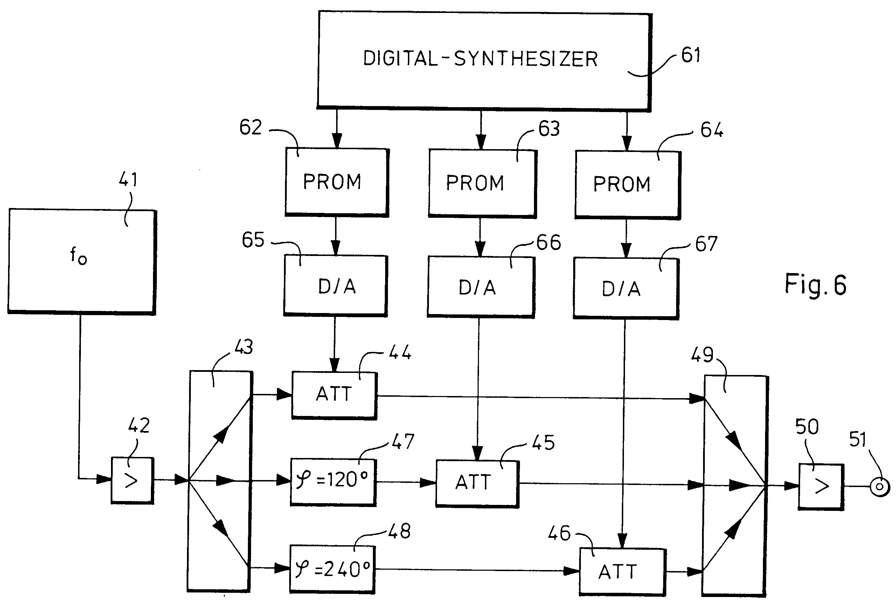

Der in Fig. 6 dargestellte Mischer unterscheidet sich von dem Quadraturmischer nach Fig. 1 darin, daß er anstelle Ringmodulatoren elektronisch steuerbare Dämpfungsglieder oder Attenuatoren enthält. Da solche Dämpfungsglieder im Gegenstatz zu Ringmodulatoren keine Ausgangssignale mit gegenüber dem Eingangssignal um 180° verschobener Phase (d.h. negative Signale) liefern können, muß den Dämpfungsgliedern das Trägersignal mit einer solchen Phasenverschiebung zugeführt werden, daß wenigstens eines der Dämpfungsglieder ein Ausgangssignal mit "negativer" Phasenlage liefert, die in Kombination mit den Ausgangssignalen der anderen Dämpfungsglieder wieder die Möglichkeit bietet, den das Ausgangssignal repräsentierenden Vektor einen vollständigen Kreis beschreiben zu lassen. Hierzu genügen drei Dämpfungsglieder, denen das Trägersignal mit einer jeweils um 120° verschobenen Phasenlage zugeführt wird.

Demgemäß weist der in Fig. 6 dargestellte Modulator wiederum einen HF-Generator 41 zur Erzeugung eines Trägersignals mit der Frequenz $f_0$ auf, dessen Ausgangssignal über einen Verstärker 42 einem Leistungsteiler 43 zugeführt wird, dessen Ausgänge mit einem ersten Dämpfungsglied 44 direkt und mit zwei weiteren Dämpfungsgliedern 45, 46 über je einen Phasenschieber 47 bzw. 48 verbunden sind. Von diesen beiden Phasenschiebern bewirkt der erste Phasenschieber 47 einen Phasenverschiebung von 120° und der zweite Phasenschieber 48 eine Phasenverschiebung von 240°. Die Ausgangssignale der Dämpfungsglieder 44, 45, 46 werden wiederum mittels eines Additionskreises 49 vereinigt und über einen weiteren Verstärker 50 dem Ausgang 51 des Mischers zugeführt.

Wie bereits erwähnt, sind die Dämpfungsglieder 44, 45, 46 elektronisch steuerbar, d.h. daß der Grad der Dämpfung durch den Dämpfungsgliedern zugeführte elektronische Signale einstellbar ist. Diese Signale werden den Dämpfungsgliedern in Form von Modulationssignalen der Frequenz $f_m$ zugeführt, die genau wie in der anhand Fig. 1 beschriebenen Weise von einem Digital-Synthesizer 61, drei digitalen Speichern 62, 63, 64 und drei Digital/Analog-Umsetzern 65, 66, 67 erzeugt werden, deren Ausgänge jeweils mit einem der Steuereingänge der Dämpfungsglieder 44, 45, 46 verbunden sind. In den Speichern 62, 63, 64 sind wiederum an Stellen, die den Winkelwerten einer periodischen Schwingung zugeordnet sind, Spannungswerten entsprechende Zahlen gespeichert, die in Abhängigkeit von dem vom Digital-Synthesizer 61 zugeführten Signalen ausgelesen und dem zugeordneten Digital/Analog-Umsetzer zugeführt werden. Die in den beispielsweise wiederum von PROMs gebildeten Speichern 62, 63, 64 enthaltenen Zahlenwerte sind in der oben beschriebenen Weise so bestimmt worden, daß sich bei zyklischer Abtastung der gespeicherten Zahlenwerte mittels des Digital-Synthesizers 61 der das Ausgangssignal bildende Vektor einen Kreis durchläuft. Auf diese Weise wird auch hier wieder bei einer Abtastung der gespeicherten Zahlenwerte mit einer der Modulationsfrequenz $f_m$ entsprechenden Taktfrequenz mittels des Digital-Synthesizers 61 ein Ausgangssignal erzeugt, das gegenüber der Trägerfre-

qunz $f_0$ um die Frequenz $f_m$ des Modulationssignals verschoben ist.

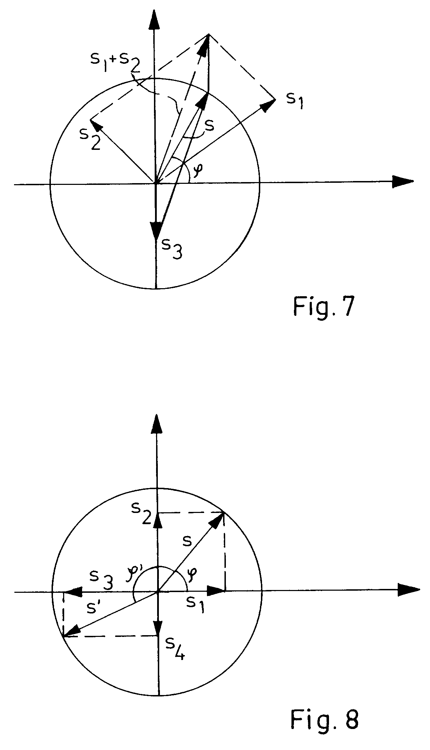

Das Diagramm nach Fig. 7 zeigt, wie aus den drei Ausgangssignalen $S_1$, $S_2$ und $S_3$ deren Phasen um 120° gegeneinander verschoben sind, ein Summensignal $S = S_1 + S_2 + S_3$ gebildet wird. Es ist ohne weiteres ersichtlich, daß durch Ändern der Amplituden der drei Komponenten $S_1$, $S_2$ und $S_3$ ein Summensignal $S$ mit beliebiger Phasenlage und konstanter Amplitude erzeugt werden kann. Der Vorgang der Erzeugung de Ausgangssignals entspricht der bekannten Erzeugung eines Drehfeldes mittels drei in der Phase gegeneinander versetzten Wechselspannungen. Wie Fig. 7 zeigt, kann dabei allerdings die Amplitude des Summensignales kleiner sein als die Amplitude einer oder auch mehrerer der drei das Summensignal bildenden Komponenten. Ferner läßt sich leicht zeigen, daß eine der drei Signalkomponenten keine Amplitudenmodulation aufzuweisen braucht, sondern konstant gehalten werden könnte, so daß bei dem Mischer nach Fig. 6 eines der gesteuerten Dämpfungsglieder entfallen könnte, auch wenn natürlich drei im Phasenwinkel gegeneinander versetzte Signale kombiniert werden müssen.

Ein der Ausführungsform nach Fig. 6 ähnlicher Mischer ließe sich auch unter Verwendung von vier Dämpfungsgliedern aufbauen, denen dann das Trägersignal mit jeweils um 90° verschobener Phase zugeführt werden müßte. Wie Fig, 8 zeigt, würden dabei die Ausgangssignale jeweils zweier Dämpfungsglieder, denen die Trägerfrequenz mit einer Phasenverschiebung von 90° zugeführt wird und die demgemäß einen Quadranten des vom Vektor beschriebenen Kreises begrenzen, ausreichen, um ein in diesem Quadranten liegendes Ausgangssignal mit beliebiger Phase zu erzeugen. So erzeugen in dem Diagramm nach Fig. 8 die Ausgangssignale $S_1$, und $S_2$, die den ersten Quadranten begrenzen, das Ausgangssigganl $S$, während die Ausgangssignale $S_3$ und $S_4$, die den dritten Quadranten begrenzen, das in diesem dritten Quadranten liegende Ausgangssignal $S'$ erzeugen. Analog lassen sich im zweiten und vierten Quadranten liegende Ausgangssignale des Mischers mittels der Ausgangssignale $S_2$ und $S_3$ bzw. $S_1$ und $S_4$ der Dämpfungglieder erzeugen. Diese Konstruktion setzt natürlich voraus, daß die Dämpfungsglieder vollständig gesperrt werden können. Eine solche Sperrung ist jedoch nicht erforderlich, wenn die bei stärkster Dämpfung verbleibenden Signale durch entsprechend größere Ausgangssignale derjenigen Dämpfungsglieder kompensiert werden, denen das Trägersignal mit einer um 180° verschobenen Phase zugeführt wird.

Es ist ersichtlich, daß die Erfindung auf einfache Weise die Möglichkeit bietet, durch einen Mischvorgang ein in der Frequenz änderbares Ausgangssignal hoher Stabilität und Reinheit zu erzeugen. Grundsätzlich kann ein nach der Erfindung ausgebildeter und betriebener Mischer mit Trägerfrequenzen von etwa 100 kHz an benutzt werden. Bei bevorzugten Einsatzgebieten treten Trägerfrequenzen von mehr als 10 MHz auf. Anwendungsbeispiele sind z.B. die Erzeugung der Entkopplungsfrequenz in einem NMR-Spektrometer, d.h. die Erzeugung einer Protonenfrequenz im 100 MHz-Bereich, die um maximal ± 100 kHz verschiebbar sein muß, um eine genaue Abstimmung auf eine NMR-Frequenz zu ermöglichen. Ein weiterer Anwendungsbereich ist die Erzeugung des Anregungssignals in einem CW-Spektrometer, dessen Frequenz ebenfalls in dem genannten Bereich liegt und um etwa ± 100 kHz fortlaufend durchstimmbar sein muß. Die obere Grenze der Arbeitsfrequenz eines solchen Mischers dürfte im Gigahertz-Bereich liegen.

**Patentansprüche**

1. Verfahren zum Vermindern des Anteils an Störsignalen einschließlich der Spiegelfrequenz im Ausgangssignal eines Mischers, der mindestens zwei Modulatoren aufweist, denen an ihrem ersten Eingang ein Trägersignal der Frequenz $f_0$ und an ihrem zweiten Eingang ein Modulationssignal der Frequenz $f_m$ derart zugeführt wird, daß die dem einen der mindestens zwei Modulatoren zugeführten Träger- und Modulationssignale gegenüber dem dem mindestens einen anderen Modulator zugeführten Träger- bzw. Modulationssignal eine vorgegebene Phasenverschiebung aufweisen, und deren Ausgangssignale zu dem Ausgangssignal des Mischers kombiniert werden, dessen Frequenz gleich der Summe der Frequenzen des Trägersignals und des Modulationssignals ist,
dadurch gekennzeichnet,
daß jedem Modulator als Modulationssignal eine Folge von M Gleichspannungssignalen mit einer der gewünschten Modulationsfrequenz $f_m$ entsprechenden Folgefrequenz zugeführt wird und die einzelnen Gleichspannungssignale jeder Folge eine solche Größe haben, daß die Kombination der allen Modulatoren gleichzeitig zugeführten m-ten Gleichspannungssignale ein Ausgangssignal des Mischers ergibt, das die Frequenz des Trägersignals, eine für alle Kombinationen der Gleichspannungssignale gleiche vorgegebene Amplitude und eine der jeweiligen Kombination der Gleichspannungssignale zugeordnete Phasenlage $m*(360°/M)$ wobei M und m ganze Zahlen mit $1 \leq m \leq M$ sind, aufweist, derart, daß die Endpunkte der für die Amplitude und die Phasenlage dieser Ausgangssignale charakteristischen Vektoren schrittweise einen vollständigen Kreis beschreiben, wobei die Folgen von M Gleichspannungssignalen experimentell ermittelt werden, und wobei sie verzerrte Sinus-Funktionen darstellen, deren Verzerrungen die Fehler des Mischers kompensieren.

2. Verfahren nach Anspruch 1, dadurch gekennzeichnet, daß die Spannungswerte der einzelnen Kombinationen von Gleichspannungssignalen als digitale Signale gespeichert, mit der die gewünschte Modulationsfrequenz ergebenden Taktfrequenz gelesen und dann in entsprechende Analogsignale umgesetzt werden, die den Modulatoren zugeführt werden.

3. Mischer zur Durchführung des Verfahrens nach Anspruch 2 mit mindestens zwei jeweils zwei Eingänge aufweisenden Modulatoren (4, 5; 44-46), einem ersten HF-Generator (1, 41) zur Erzeugung eines Trägersignals mit der Frequenz $f_0$, dessen Ausgang mit dem ersten Eingang des einen Modulators direkt und mit dem ersten Eingang des mindestens einen anderen Modulators über einen Phasenschieber (6, 47, 48) verbunden ist, und einem Generator (32, 112, 113, 14, 15; 61-67) zur Erzeugung von einer der Anzahl der Modulatoren gleichen Anzahl gegeneinander phasenverschobenen Modulationssignalen mit der Frequenz $f_m$, von denen jeweils eines dem zweiten Eingang eines der Modulatoren zugeführt wird, dadurch gekennzeichnet, daß der Generator zur Erzeugung der gegeneinander phasenverschobenen Modulationssignale als Digital-Synthesizer ausgebildet ist, Welcher Speicher für Zahlen, die Winkelwerten zugeordneten Spannungswerten des Modulationssignals entsprechen, den Speichern nachgeschaltete Digital/Analog-Umsetzer, deren Ausgänge mit dem zweiten Eingang je eines der Modulatoren verbunden sind, und eine Einrichtung (32, 61) zum Auslesen der Zahlen aus den Speichern nach einem die Modulationsfrequenz bestimmenden Takt und Zuführen der Zahlen zu den Digital/Analog-Umsetzern (14, 15, 65-67) umfaßt, welche den Modulatoren den Zahlen entsprechende Spannungswerte zuführen, daß die Speicher für jeden Winkelwert eine experimentell ermittelte Zahlenkombination enthalten, die als Ausgangssignal des Mischers ein Signal mit der Trägerfrequenz und vorgegebener fester Amplitude und einer mit dem Winkelwert übereinstimmenden Phasenlage ergibt, wobei die den Zahlen entsprechenden Spannungswerte, die den Modulatoren zugeführt werden, verzerrte Sinus-Funktionen darstellen, deren Verzerrungen die Fehler des Mischers kompensieren.

4. Mischer nach Anspruch 3, dadurch gekennzeichnet, daß er zwei Ringmodulatoren aufweist, denen das Trägersignal mit einer relativen Phasenverschiebung von 90° zugeführt wird.

5. Mischer nach Anspruch 3, dadurch gekennzeichnet, daß er als Modulatoren n elektronisch steuerbare Dämpfungsglieder (44-46) aufweist, denen das Trägersignal mit einer relativen Phasenverschiebung von 360°/n zugeführt wird, wobei n = 3 oder 4 ist.

6. Mischer nach Anspruch 5, dadurch gekennzeichnet, daß eines der Dämpfungsglieder auf eine vorgegebene konstante Dämpfung eingestellt ist.

**Claims**

1. Method for the reduction of contributions from interfering signals, including the mirror frequency, in the output signal of a mixer exhibiting at least two modulators to whose first input a carrier signal of frequency $f_0$ and to whose second input a modulation signal of frequency $f_m$ are introduced in such a fashion that the carrier and modulation signals introduced to the first of the at least two modulators exhibits a predetermined phase shift relative to the carrier or modulation signal introduced to the at least one other modulator and their output signals are combined to the output signal of the mixer, whose frequency is equal to the sum of the frequencies of the carrier signal and the modulation signal, characterized in that each modulator is fed a modulation signal comprising a sequence of M, D.C. voltage signals with a sequence frequency corresponding to the desired modulation frequency $f_m$, and the individual D.C. voltage signals of each sequence exhibit such a magnitude that the combination of the m-fold D.C. voltage signals which are simultaneously fed to all the modulators results in a mixer output signal which exhibits the frequency of the carrier signal, a predetermined amplitude which is constant for all combinations of the D.C. voltage signal, and a phase position $m*(360°/M)$ assigned to the prevailing combination of D.C. voltage signals, whereby M and m are whole numbers with $1 \leq m \leq M$, in such a way that the end points of the vectors characteristic of the amplitudes and the phase positions of these output signals stepwise define a complete circle, whereby the sequence of M, D.C. voltage signals are determined experimentally, and whereby they form distorted sine functions whose distortion compensates for the errors in the mixer.

2.  Method according to claim 1 characterized in that the voltage values of the individual combinations of D.C. voltage signals are stored as digital signals, are read with the clock frequency determining the desired modulation frequency, and are then are transformed into corresponding analog signals which are fed to the modulators.

3.  Mixer for carrying out the method according to claim 2 with at least two modulators (4, 5; 44-46) each exhibiting two inputs, a first RF generator (1, 41) for the production of a carrier signal of the frequency $f_0$, whose output is directly connected to the first input of one modulator and, via a phase shifter (6, 47, 48), to the first input of the at least one other modulator, and with a generator (32, 112, 113, 14, 15; 61-67) for the production of a number, equal to the number of modulators, of mutually phase shifted modulation signals with frequency $f_m$ from which one of each is fed to the second input of one of the modulators, characterized in that the generator for the production of the mutually phase shifted modulation signals is configured as a digital synthesizer including memories for numbers which correspond to the voltage values of the modulation signal associated with the angular values, a digital/analog converter switched in after the memory whose outputs are connected to the second input of one modulator each, and a device (32, 61) to read out the numbers from the memory at a rate determining the modulation frequency and to introduce the numbers to the digital/analog converters (14, 15; 65-67) which supply the voltage values corresponding to the numbers to the modulators, and in that the memories contain an experimentally extracted combination of numbers for every angular value which determines a mixer output signal with the carrier frequency, a predetermined constant amplitude, and a phase position corresponding to the angular value, whereby the voltage values corresponding to the numbers which are fed to the modulators represent distorted sine functions whose distortion compensates for the error of the mixer.

4.  Mixer according to claim 3 characterized in that it exhibits two ring modulators to which the carrier signal is introduced with a relative phase shift of 90°.

5.  Mixer according to claim 3 characterized in that it exhibits n electronically controllable attenuators (44-46) as modulators to which the carrier signal is introduced with a relative phase shift of 360°/n, whereby n = 3 or 4.

6.  Mixer according to claim 5 characterized in that one of the attenuators is adjusted to a predetermined constant attenuation.

**Revendications**

1.  Procédé pour réduire la fraction de signaux parasites, y compris la fréquence-image, dans le signal de sortie d'un mélangeur qui comprend au moins deux modulateurs, auxquels sont fournis en première entrée un signal porteur de fréquence $f_0$ et en seconde entrée un signal de modulation de fréquence $f_m$, de telle manière que le signal porteur et le signal de modulation fournis à l'un des au moins deux modulateurs présentent un décalage de phase prédéterminé par rapport au signal porteur et au signal de modulation fournis à l'autre modulateur, les signaux de sortie des deux modulateurs étant combinés afin de former le signal de sortie du mélangeur dont la fréquence est égale à la somme des fréquences du signal porteur et du signal de modulation, caractérisé en ce que l'on fournit à chaque modulateur en tant que signal de modulation une suite de M signaux à tension continue avec une fréquence de succession qui correspond à la fréquence de modulation désirée $f_m$, et les signaux individuels à tension continue de chaque succession ont une telle amplitude que la combinaison des m-ièmes signaux à tension continue fournis simultanément à tous les modulateurs produit un signal de sortie du mélangeur qui présente la fréquence du signal porteur, une amplitude prédéterminée égale pour toute les combinaisons des signaux à tension continue, et une situation de phase associée à la combinaison respective des signaux à tension continue égale à m*(360°/M) où M et m sont des nombres entiers tels que 1≤m≤M, de telle manière que les points finals des vecteurs caractéristiques pour l'amplitude et la phase de ces signaux de sortie décrivent pas à pas un cercle complet, les successions de M signaux à tension continue étant déterminées de manière expérimentale, et ils représentent des fonctions sinus affectées de distorsion, dont les distorsions compensent les erreurs du mélangeur.

**2.** Procédé selon la revendication 1, caractérisé en ce que les valeurs de tension des combinaisons individuelles de signaux à tension continue sont stockées sous la forme de signaux numériques, avec lesquels on lit la fréquence de cadencement qui produit la fréquence de modulation désirée, et on la transforme alors en signaux analogiques correspondants, qui sont fournis aux modulateurs.

**3.** Mélangeur pour mise en oeuvre du procédé selon la revendication 2, comprenant au moins deux modulateurs (4, 5; 44, 46) qui présentent chacun deux entrées, un premier générateur HF (1, 41) pour produire un signal porteur de fréquence $f_0$, dont la sortie est reliée directement à la première entrée de l'un des modulateurs et est reliée par l'intermédiaire d'un décaleur de phase (6, 47, 48) à la première entrée de l'autre modulateur, et un générateur (32, 112, 113, 14, 15; 61-67) pour produire un nombre, égal au nombre des modulateurs, de signaux de modulation de fréquence $f_m$ décalés en phase les uns par rapport aux autres, parmi lesquels un signal respectif est fourni à la seconde entrée de l'un des modulateurs, caractérisé en ce que le générateur pour produire les signaux de modulation décalés en phase les uns par rapport aux autres est réalisé sous la forme d'un synthétiseur numérique, qui comprend des mémoires pour des nombres qui correspondent à des valeurs de tension du signal de modulation, associées à des valeurs angulaires, des transformateurs numériques/analogiques branchés à la suite des mémoires, dont les sorties sont reliées à la seconde entrée d'un modulateur respectif, et des moyens (32, 61) pour lire les nombres dans les mémoires à une cadence qui détermine la fréquence de modulation et pour fournir les nombres aux convertisseurs numériques/analogiques (14, 15, 65-67), lesquels fournissent aux modulateurs des valeurs de tension correspondant aux nombres, en ce que les mémoires contiennent une combinaison de nombres déterminée expérimentalement pour chaque valeur angulaire, combinaison qui produit en tant que signal de sortie du mélangeur un signal ayant la fréquence porteuse et une amplitude fixe prédéterminée, et une situation de phase qui coïncide avec la valeur angulaire, les valeurs de tension qui correspondent aux nombres et sont fournies aux modulateurs représentent des fonctions sinus affectées de distorsions, dont les distorsions compensent les erreurs du mélangeur.

**4.** Mélangeur selon la revendication 3, caractérisé en ce qu'il comprend deux modulateurs annulaires auxquels est fourni le signal porteur avec un décalage de phase relatif de 90°.

**5.** Mélangeur selon la revendication 3, caractérisé en ce qu'il comprend en tant que modulateurs n atténuateurs (44, 46) qui peuvent être commandés électroniquement, auxquels le signal porteur est fourni avec un décalage de phase relatif de 360°/n où n = 3 ou 4.

**6.** Mélangeur selon la revendication 5, caractérisé en ce que l'un des atténuateurs est réglé à une atténuation constante prédéterminée.

DIGITAL-SYNTHESIZER

PROM

PROM

D / A

D / A

$\varphi = 90°$

$f_o$

Fig. 1

Fig. 2

Fig. 3

Fig. 4

a) $f_O$

b) $f_O + 100\,kHz$

c) $f_O - 100\,kHz$

d) $f_O + 200\,kHz$

e) $f_O - 200\,kHz$

f) $f_O + 300\,kHz$

g) $f_O - 300\,kHz$

h) $f_O + 400\,kHz$

i) $f_O - 400\,kHz$

Fig. 5

Fig. 6

EP 0 304 737 B1

Fig. 7

Fig. 8